## Europäisches Patentamt
## European Patent Office
## Office européen des brevets

(11) Veröffentlichungsnummer: **0 237 922 B1**

(12) # EUROPÄISCHE PATENTSCHRIFT

(45) Veröffentlichungstag der Patentschrift: **23.06.93**

(21) Anmeldenummer: **87103401.3**

(22) Anmeldetag: **10.03.87**

(51) Int. Cl.5: **H01S 3/133**, H01S 3/103, H04B 10/02

(54) Verfahren zur Regelung der optischen Leistung eines Lasers und Schaltung zur Ausübung des Verfahrens.

(30) Priorität: **18.03.86 DE 3608930**

(43) Veröffentlichungstag der Anmeldung:
**23.09.87 Patentblatt 87/39**

(45) Bekanntmachung des Hinweises auf die Patenterteilung:
**23.06.93 Patentblatt 93/25**

(84) Benannte Vertragsstaaten:
**AT BE CH DE ES FR GB IT LI NL SE**

(56) Entgegenhaltungen:
**FR-A- 2 448 274**
**GB-A- 2 025 121**
**US-A- 4 277 846**
**US-A- 4 347 610**
**US-A- 4 399 566**

**ELECTRONICS LETTERS, Band 16, Nr. 1, 3. Jänner 1980, London CHEN "Simultaneous Feedback Control of Bias and Modulation Currents for Injection Lasers" Seiten 7,8**

**DEUXIEME COLLOQUE EUROPEEN SUR LES TRANSMISSIONS PAR FIBRES OPTIOUES, Paris, 27.-30. September 1976 EPWORTH**

**"Sous-ensembles pour liaisons optiques a grande vitesse" Seiten 377-382**

(73) Patentinhaber: **Alcatel SEL Aktiengesellschaft**
**Lorenzstrasse 10**
**W-7000 Stuttgart 40(DE)**

(72) Erfinder: **Kaiser, Norbert**
**Calwer Strasse 58**
**W-7146 Tamm(DE)**
Erfinder: **Mittrich, Martin**
**Riedstrasse 8**
**W-7250 Leonberg(DE)**

(74) Vertreter: **Hösch, Günther, Dipl.-Ing. et al**
**Alcatel SEL AG Patent- und Lizenzwesen**
**Postfach 30 09 29**
**W-7000 Stuttgart 30 (DE)**

**Beschreibung**

Die vorliegende Erfindung bezieht sich auf einen optischen Sender und auf ein Verfahren zum Betreiben des optischen Senders nach dem Oberbegriff des Patentanspruchs 1 bzw. 8.

Ein derartiger optischer Sender und ein derartiges Verfahren sind aus der US-A-4 277 846 bekannt. Der dort beschriebene optische Sender weist eine Laserdiode zum Senden von NRZ-Impulsen für die digitale Nachrichtenübertragung auf. Im Falle eines "0"-Impulses wird der Laserdiode ein Vorstrom zugeführt, der unterhalb des Schwellstroms der Laserdiode liegt. Im Falle eines "1"-Impulses wird dem Vorstrom ein Modulationsstrom hinzugefügt.

Aufgrund der Alterung der Laserdiode nimmt der Schwellstrom im Laufe der Zeit zu, die Quantenausbeute hingegen ab. Aufgrund dessen ist es notwendig, den Vorstrom und den Modulationsstrom entsprechend anzupassen. Dies geschieht, indem eine Photodiode die jeweilige Lichtleistung mißt und in einen Strom umsetzt, der einen Gleich- und einen Wechselanteil enthält. Der Mittelwert dieses Stroms wird benutzt, um den Vorstrom der Laserdiode zu regeln. Die Differenz zwischen dem Maximalwert des Wechselanteils und dem Mittelwert des von der Photodiode erzeugten Stroms wird benutzt, um den Modulationsstrom der Laserdiode zu regeln.

Der Modulationsstrom wird mittels einer Regeleinrichtung geregelt, die zwei Operationsverstärker aufweist; zur Verstärkung des Ausgangssignals der Operationsverstärker ist als Stellglied ein Transistor vorhanden, der kollektorseitig mit der Laserdiode und emitterseitig mit einer Spannungsquelle verbunden ist. Die Regeleinrichtung enthält neben dem Differenzverstärker noch zwei Filter, ein Potentiometer und Widerstände.

Die Druckschrift Electronics Letters 16 (1980), S. 7-8, gibt im wesentlichen den gleichen optischen Sender an.

Aus der US-A-4 347 610, insbesondere Fig. 3 und Fig. 4, ist je eine Schaltung für eine Laserdiode bekannt, durch die sich Vorstrom und Modulationsstrom der Laserdiode regeln lassen. Dabei wird in dem einen Ausführungsbeispiel der Modulationsstrom durch ein ein Zeilensynchronisationssignal und einen Tonträger enthaltendes analoges Videosignal erzeugt (Fig. 3).

In dem anderen Ausführungsbeispiel wird der Modulationsstrom in einem Verstärker erzeugt, dem ein Nachrichtensignal und die Summe zweier binärer Hilfssignale zugeführt werden (Fig. 4).

Aus der US-A-4 399 566 ist ebenfalls ein optischer Sender mit Regelschaltungen zum Regeln des Vorstroms und des Modulationsstroms einer Laserdiode bekannt. Dieser optische Sender ist sehr aufwendig, da er beispielsweise zehn Operationsverstärker enthält.

Es ist die Aufgabe der Erfindung, einen optischen Sender zu schaffen, der sich mit geringem Schaltungsaufwand herstellen läßt. Es ist außerdem die Aufgabe der Erfindung, ein Verfahren zum Betreiben des optischen Senders zu schaffen.

Die Aufgabe wird, wie in Patentanspruch 1 bzw. 8 angegeben, gelöst.

Durch die Regelung auf minimale Größe der im Linienspektrum auftretenden Spektrallinie bei Betrieb des Lasers im Bereich des Kennlinienknicks ist die optische Ausgangsleistung unabhängig von Exemplarstreuungen, der Lasertemperatur und den Alterungseinflüssen.

Weitere vorteilhafte Einzelheiten der Erfindung sind in den Unteransprüchen angegeben und nachfolgend anhand eines Ausführungsbeispieles beschrieben.

Es zeigen:

Fig. 1 die Kennlinie von Laserdioden und

Fig. 2 ein Schaltungsprinzip zur Ausübung des Verfahrens.

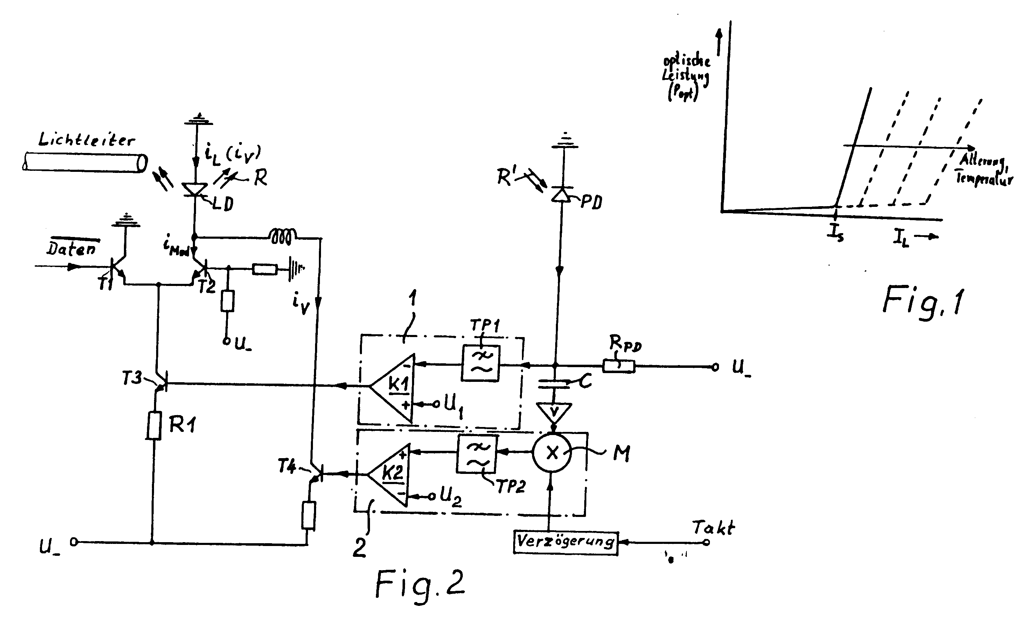

Die Fig. 1 zeigt die Kennlinie einer Halbleiterlaserdiode. Wie erkennbar, tritt eine große Lichtausbeute erst ab einem Schwellstrom $I_S$ ein. Für den Fall der Datenübertragung oder Modulation der Lichtleistung muß daher der Laser im Bereich des steilen Kennlinienastes betrieben werden. Durch Alterung und Temperatur wird der Schwellstrom immer größer und die Steilheit des steilen Astes nimmt ab. Die bisherigen Regelungen berücksichtigen diese Effekte nicht oder mit aufwendiger Schaltungstechnik. Überlicherweise wird ein Vorstrom $I_V$ eingestellt und konstant gehalten, der größer ist als der Schwellstrom $I_S$. Diesem Vorstrom $I_V$ wird ein Modulationsstrom hinzugefügt, der dem zu übertragenden Signal entspricht, für das hier positive Werte angenommen sind.

Insbesondere bei digitaler Signalübertragung wird dann, wenn der Laserstrom $I_L$ bei übertragung einer "0" kleiner ist als der Schwellstrom $I_S$, die Flanke von logisch "0" nach logisch "1" verzögert in Lichtleistung umgesetzt, entsprechend der Formel

$$t_v = \tau \cdot \ln\left(\frac{I_{Mod}}{I_{Mod} + I_v - I_S}\right) \; ; \quad I_v \leq I_S$$

mit

$\tau$ = Elektronenlebensdauer (einige ns)

$t_v$ = Verzögerungszeit

Um also eine "1" ungestört übertragen zu können, sollte die Forderung $I_L \geqq I_S$ möglichst gut eingehalten werden.

Da die Spitzen lei stung des Lasers begrenzt ist und das Verhältnis zwischen den optischen Leistungen der übertragenen "1" und "0" möglichst groß sein soll, besteht die Forderung, den minimalen Laserstrom (bei der Übertragung "0") nahe dem Schwellstrom $I_S$ einzustellen. Dieser Schwellstrom ist nicht nur von Exemplar zu Exemplar verschieden, sondern auch, wie im Bild 1 dargestellt, stark temperatur- und alterungsabhängig. Zusätzlich flacht die Steigung der Kennlinie mit zunehmender Temperatur und Alterung ab. Um diese Effekte zu berücksichtigen, muß daher bei Regelung des Vorstroms $I_v$ auf einen konstanten Wert dieser entweder größer als der Schwellstrom gewählt werden. Dann kann aber nicht die optimale mögliche Lichtleistung übertragen werden. Oder der Vorstrom wird nahe dem Schwellstrom $I_S$ konstant eingeregelt und die optimale Lichtleistung wird ausgenutzt, dann kann die Verschiebung der Kennlinie zur Senkung der Lichtleistung führen.

Die Erfindung geht von der folgenden Erkenntnis aus:

Bei einer digitalen Übertragung von NRZ-Pulsen und der Bitrate $f_B$ beträgt die kürzeste elektrische Pulsdauer

$$T = \frac{1}{f_B}$$

(Taktperiode). Eine statistische Folge von Pulsen der Dauer T im Raster n•T (n ganzzahlig) hat ein Leistungsdichtespektrum, dessen Anteil bei $f_B$ verschwindet. Wird die Einschaltverzögerung des Lasers erhöht durch Verringerung des Vorstroms $I_v$, so sinkt die optische Pulsbreite und damit wird die kürzeste optische Pulsdauer kleiner als T. Im Leistungsdichtespektrum des optischen Ausgangssignals des Lasers erscheint dann bei der Frequenz $f_B$ eine Linie, die mit zunehmender Einschaltverzögerung größer wird.

Erfindungsgemäß wird nun der Laser so betrieben, daß er im Bereich des Kennlinienknicks arbeitet und zwar derart, daß im Frequenzspektrum eine Linie auftritt, jedoch mit minimaler Größe. Das Kriterium ist also das Vorhandensein einer Verzögerung, die zwecks noch ungestörter Übertragung der Signale sehr gering gehalten wird und damit eine maximale optische Lichtleistung zu übertagen gestattet.

Die bei der Einschaltverzögerung auftretende Spektrallinie kann beispielsweise durch Mischen mit der Taktfrequenz $f_B$ detektiert werden. Der niederfrequente Anteil des Signals am Ausgang des Mischers wird dazu benutzt, den Vorstrom $I_v$ so zu regeln, daß die Verzögerungszeit einen bestimmten Wert unterschreitet (im nachfolgenden Ausführungsbeispiel bestimmt der Sollwert $I_v$ diese minimal zugelassene Verzögerung). Durch diese untere Grenze soll erreicht werden, daß bei einem praktischen System, bei dem z.B. die Spektrallinie auch bei Betrieb oberhalb des Schwellstroms nicht ganz verschwindet, der Vorstrom nicht zu weit hoch geregelt wird. Der Gleichanteil der Laserleistung könnte dabei zu groß werden bzw. der Laser würde zerstört werden.

Prinzipiell ist es bei einem Halbleiterlaser, dessen Abnahme der Steilheit mit Temperatur und Alterung tolerierbar ist, d.h. dessen Ausgangsleistung entsprechend dieser Änderungen abnehmen darf, möglich, mit Hilfe der Spektrallinie bei $f_B$ nur den Vorstrom $I_v$ zu regeln und nicht den Modulationsstrom $I_{Mod}$, der in diesem Fall fest eingestellt, d.h. dem jeweiligen Laserexpemplar angepaßt wird.

Nachfolgend wird die Erfindung anhand des in Fig.2 dargestellten Schaltungsprinzips beschrieben. Das invertierte Datensignal liegt an einem Differenzverstärker, bestehend aus einer ersten Transistorstufe T1 und einer zweiten Transistorstufe T2 sowie der Stromquelle, gebildet aus der Transistorstufe T3 und dem Widerstand R1, an. Der Ausgang des Differenzverstärkers liefert den Modulationsstrom $I_{Mod}$ für die Laserdiode LD. Ein Teil der von der Laserdiode LD gegebenen optischen Leistung, hier ein Teil R' des Rücklichts R, fällt auf eine Fotodiode PD und wird in dieser in einen zur Leistung proportionalen Strom umgesetzt, der über einen Widerstand $R_{PD}$ einen Spannungsabfall erzeugt. Der Mittelwert dieser Spannung wird in einem ersten Tiefpaß TP1 gebildet und mit dem Sollwert der mittleren Leistung U1 in dem als Regeleinrichtung 1 dienenden Komparator K1 verglichen. Wird diese Leistung durch eine Störung verringert, beispielsweise durch Temperaturerhöhung des Lasers, so sinkt der Mittelwert des Fotodiodenstroms und damit die Ausgangsspannung des ersten Tiefpasses TP1. Der Komparator K1 vergrößert seine Ausgangsspannung und damit nimmt der Modulationsstrom $I_{Mod}$, gesteuert durch die Transistorstufe T3, zu.

Der in der Fotodiode PD erzeugte Wechselanteil des Stromes gelangt über einen Kondensator C und einen Verstärker V an einen Multiplizierer M, dessen Ausgang über einen zweiten Tiefpaß TP2 an den einen Eingang eines zweiten als Regeleinrichtung 2 dienenden Komparators K2 angeschlossen ist. Das Taktsignal (Bitfolgefrequenz $F_B$) wird an den zweiten Eingang des Multiplizierers M angelegt. Die Phasenbeziehung zwischen beiden Eingangssignalen am Multiplizierer M wird erfindungsgemäß durch eventuelle Verzögerung des Taktsignals so gewählt, daß der Gleichanteil des Ausgangssignals des Multiplizierers M möglichst groß ist und ein ausreichender Regelbereich vorhanden ist, d.h. beim Einschalten des Gerätes, bei dem sich durch unterschiedliche Regelzeitkonstanten (wie später noch erläutert wird) zuerst ein maximaler Modulationsstrom $I_{Mod}$ bei minimalem Vorstrom $I_V$ einstellt, muß das Ausgangssignal des zweiten Tiefpasses TP2 so groß sein, daß ein den Vorstrom $I_V$ regelndes Stellglied, z.B. der vom Komparator K2 angesteuerte Transistor T4 aufgesteuert, d.h. der Vorstrom $I_V$ des Lasers LD erhöht wird. An den zweiten Eingang des zweiten Komparators K2 wird die dem Sollwert der o.g. Frequenzlinie im Leistungsdichtespektrum entsprechende Spannung U2 angelegt.

Ein weiterer besonderer Vorteil der Erfindung besteht darin, daß bei Ausfall von Daten oder des Taktes der Laser LD automatisch vor zu großen Strömen geschützt wird, die beim Wiederkommen von Daten bzw. des Taktsignals bei anderen Laserregelungen ohne speziellen Schutz auftreten können. Bei der bekannten Mittelwertregelung steigt, falls keine spezielle Schutzvorrichtung vorgesehen ist, die die Daten überwacht, der Vorstrom bei Anliegen einer Dauer-Null am Dateneingang an, bis der eingestellte Mittelwert der Ausgangsleistung erreicht ist. Der Vorstrom nimmt deshalb den Wert

$$I_S + \frac{I_{Mod}}{2}$$

an, steigt also über den Schwellwert. Wird nun der Dateneingang von "0" auf "1" geschaltet, so wird momentan der Modulationsstrom dazugeschaltet, d.h. der vorher eingestellte Maximalstrom $I_S$ plus $I_{Mod}$ wird überschritten und der Laser kann beschädigt oder sogar zerstört werden. Bei Anwendung der Erfindung erscheint nach Ausfall der Daten und/oder des Taktes ein minimales Signal am Ausgang des zweiten Tiefpasses TP2. Der Vorstrom wird also auf den oben erwähnten minimalen Wert reduziert. Der Modulationsstrom erhöht sich im ungünstigsten Fall auf seinen maximalen Wert, der zusammen mit dem minimalen Vorstrom bei heute üblichen Lasern nicht den Stromspitzenwert überschreitet. Beim Wiedereinschalten von Daten und/oder des Taktes regelt nun der zweite Komparator K2 den Vorstrom langsam hoch und entsprechend nimmt der Modulationsstrom ab. Die Regelschleife für den Modulationsstrom muß daher eine höhere Grenzfrequenz als die des Vorstroms besitzen. Unterschiedliche Zeitkonstanten sind auch zum Entkoppeln der beiden Regelschleifen notwendig.

Heutige Gehäuse für Halbleiterlaser, die zur optischen Nachrichtenübertragung verwendet werden, enthalten üblicherweise außer der Laser-Lichtleitfaserankopplung auch die Fotodiode. Bei späterer Massenproduktion kann davon ausgegangen werden, daß die Koppelverluste Laser-Lichtleitfaser und Laser-Fotodiode und der Wirkungsgrad der Fotodiode, d.h. die Umsetzung des Lichtes in Strom, von Exemplar zu Exemplar so gering streuen, daß die dadurch hervorgerufenen Leistungsänderungen in der Faser hingenommen werden können. Mit der vorliegenden Erfindung muß die Elektronik dann nicht mehr auf das Laserexemplar abgestimmt werden, da nicht nur der Vorstrom sondern auch der Modulationsstrom nachgeregelt werden, d.h. unterschiedliche Kennlinien werden ausgeglichen.

**Patentansprüche**

1. Optischer Sender für die digitale Nachrichtenübertragung mittels NRZ-Impulsen, der eine einen Schwellstrom ($I_S$) aufweisende Laserdiode (LD) enthält, deren Betriebsstrom sich aus einem Vorstrom ($I_V$) und einem Modulationsstrom ($I_{Mod}$) zusammensetzt, und der eine Photodiode (PD) zur Messung der optischen Leistung der Laserdiode (LD) und eine erste Regeleinrichtung (2), durch die der Vorstrom ($I_V$) und der Modulationsstrom ($I_{Mod}$) mittels eines von der Photodiode (PD) erzeugten, einen Wechselanteil enthaltenden Stroms regelbar sind, sowie ein erstes Stellglied enthält,
**dadurch gekennzeichnet,**
daß die erste Regeleinrichtung (2) einen Multiplizierer (M) enthält, durch den der Wechselanteil des von der Photodiode (PD) erzeugten Stroms mit einem Taktsignal multiplizierbar ist, dessen Frequenz der Bitfolgefrequenz ($f_B$) der NRZ-Impulse entspricht, und daß der Vorstrom ($I_V$) durch ein von der ersten Regeleinrichtung (2) erzeugtes Ausgangssignal mittels des ersten Stellglieds auf einen Wert unterhalb des Schwellstroms ($I_S$) einstellbar ist.

2. Optischer Sender nach Anspruch 1, dadurch gekennzeichnet, daß die erste Regeleinrichtung (2) einen ersten Tiefpaß (TP2), der dem Multiplizierer (M) nachgeschaltet ist, und einen Komparator (K2) enthält, dem ein Ausgangssignal des ersten Tiefpasses (TP2) und eine Referenzspannung (U2) zuführbar sind, und daß die Referenzspannung (U2) dem Sollwert der Bitfolgefrequenz ($f_B$) entspricht.

3. Optischer Sender nach Anspruch 1 oder 2, dadurch gekennzeichnet, daß er eine zweite Regeleinrichtung (1) enthält, durch die mittels eines zweiten Stellglieds der Modulationsstrom ($I_{Mod}$) in Abhängigkeit vom Gleichanteil des von der Photodiode (PD) gelieferten Stroms derart einstellbar ist, daß die mittlere Leistung der Laserdiode (LD) konstant ist.

4. Optischer Sender nach Anspruch 3, dadurch gekennzeichnet, daß die zweite Regeleinrichtung (1) einen zweiten Tiefpaß (TP1) und einen zweiten Komparator (K1) enthält, dem das Ausgangssignal des zweiten Tiefpasses (TP1) und eine zweite Referenzspannung (U1) zuführbar sind, und daß diese dem Sollwert der mittleren Leistung der Laserdiode (LD) entspricht.

5. Optischer Sender nach Anspruch 3 oder 4, dadurch gekennzeichnet, daß die Regelung der Laserdiode (LD) mit der zweiten Regeleinrichtung (1) eine höhere Grenzfrequenz, d.h. eine kleinere Regelzeitkonstante, aufweist als die Regelung mit der ersten Regeleinrichtung (2).

6. Optischer Sender nach Anspruch 1 oder 2, dadurch gekennzeichnet, daß einem der beiden Eingänge des Multiplizierers (M) eine Verzögerungseinrichtung vorgeschaltet ist, deren Verzögerung so einstellbar oder einregelbar ist, daß durch die Phasenverschiebung zwischen den Eingangssignalen des Multiplizierers (M) ein optimaler Gleichanteil im Ausgangssignal des Multiplizierers (M) auftritt.

7. Optischer Sender nach einem der vorhergehenden Ansprüche, dadurch gekennzeichnet, daß die Stellglieder aus wenigstens je einer Transistorstufe (T3, T4) bestehen und der Ausgang je eines Komparators (K1, K2) mit dem Steuereingang des jeweils zugeordneten Stellglieds verbunden ist.

8. Verfahren zum Betreiben des optischen Senders nach Anspruch 1, bei dem die optische Leistung der Laserdiode, die einen sich aus dem Vorstrom und dem Modulationsstrom zusammensetzenden Betriebsstrom hat, und bei dem der Vorstrom und der Modulationsstrom getrennt in Abhängigkeit von der optischen Leistung der Laserdiode durch Messung eines Teilstrahls des Laserstrahls und durch Vergleich des daraus erhaltenen Signals mit einem Referenzsignal durch die erste Regeleinrichtung geregelt werden,

**dadurch gekennzeichnet,**
daß der Vorstrom oder der Vorstrom und der Modulationsstrom so geregelt wird bzw. werden, daß die Laserdiode im Bereich des Kennlinienknickes (Schwellstrom) arbeitet, so daß eine Verringerung der Übertragungsbandbreite bzw. eine Einschaltverzögerung und dadurch eine bestimmte Spektrallinie im Leistungsspektrum der optischen Leistung der Laserdiode auftritt, daß diese Spektrallinie durch eine Meßeinrichtung gemessen und aus dem Meßwert ein Steuersignal gebildet wird, das über die erste Regeleinrichtung den Vorstrom oder den Vorstrom und den Modulationsstrom so regelt, daß die Spektrallinie unterhalb eines maximal zulässigen Wertes bleibt.

9. Verfahren nach Anspruch 8, dadurch gekennzeichnet, daß eine dem gemessenen Laserteilstrom entsprechende Spannung einem ersten Tiefpaß zugeführt wird, der daraus einen Spannungsmittelwert bildet und dem einen Eingang eines ersten Komparators eingegeben wird, der durch Vergleich mit einer dem anderen Eingang zugeführten Referenzspannung für den Modulationsstrom diesen auf eine vorgegebene mittlere Leistung einregelt.

10. Verfahren nach Anspruch 8 oder 9, dadurch gekennzeichnet, daß die Spektrallinie im Leistungsspektrum dadurch detektiert wird, daß der hochfrequente Anteil des gemessenen Laserteilstrahls und die der Bitfolgefrequenz oder einem Vielfachen davon entsprechende Taktfrequenz des Systems einem Multiplizierer zugeführt und das daraus gebildete Ausgangssignal über einen zweiten Tiefpaß geleitet als Regelgröße dem einen Eingang eines zweiten Komparators zugeleitet wird, dem am anderen Eingang eine Referenzspannung aufgedrückt ist, und daß das durch Vergleich der beiden Eingangsgrößen gebildete Ausgangssignal den Vorstrom auf einen Wert regelt, der der gewünschten minimalen Größe der Spektrallinie im Leistungsspektrum der optischen Laserleistung entspricht.

**Claims**

1. An optical transmitter for digital communication using NRZ pulses which includes a laser diode (LD) having a threshold current ($I_S$) and an operating current which is composed of a bias current ($I_V$) and a modulating current ($I_{Mod}$), a photodiode (PD) for measuring the optical power of the laser diode (LD), a first control device (2) for controlling the bias current ($I_V$) and the modulating current ($I_{Mod}$) by means of a current produced by the photodiode (PD) and containing an alternating component, and a first final control element,
**characterized in**
that the first control device (2) includes a multiplier (M) for multiplying the alternating component of the photodiode (PD) by a clock signal whose frequency is equal to the bit rate ($f_B$) of the NRZ pulses, and that the bias current ($I_V$) is adjustable to a value below the threshold current ($I_S$) by means of the first final control element in response to an out put signal generated by the first control device (2).

2. An optical transmitter as claimed in claim 1, characterized in that the first control device (2) includes a first low-pass filter (TP2), which follows the multiplier (M), and a comparator (K2) which can be supplied with an output signal from the first low-pass filter (TB2) and a reference voltage (U2), and that the reference voltage (U2) corresponds to the desired value of the bit rate ($f_B$).

3. An optical transmitter as claimed in claim 1 or 2, characterized in that it includes a second control device (1) for adjusting the modulating current ($I_{Mod}$) as a function of the direct component of the output current of the photo diode (PD) by means of a second final control element in such a way that the average power of the laser diode (LD) is constant.

4. An optical transmitter as claimed in claim 3, characterized in that the second control device (1) contains a second low-pass filter (TP1) and a second comparator (K1) which can be supplied with the output of the second low-pass filter (TP1) and a second reference voltage (U1), and that the second reference voltage (U1) corresponds to the desi red value of the average power of the laser diode (LD).

5. An optical transmitter as claimed in claim 3 or 4, characterized in that the control of the laser diode (LD) with the second control device (1) has a higher cutoff frequency, i.e., a shorter time constant, than the control with the first control device (2).

6. An optical transmitter as claimed in claim 1 or 2, characterized in that one of the two inputs of the multiplier (M) is preceded by a delay device whose delay is so adjustable or controllable that as a result of the phase difference between the inputs to the multiplier (M), an optimum direct component occurs in the output of the multiplier (M).

7. An optical transmitter as claimed in any one of the preceding claims, characterized in that the final control elements each consist of at least one transistor stage (T3, T4) having its control input connected to the output of an associated comparator (K1, K2).

8. A method of operating the optical transmitter according to claim 1 wherein the optical power output of the laser diode, which has an operating current composed of the bias current and the modulating current, and wherein the bias current and the modulating current are controlled separately by means of the first control device as a function of the optical power output of the laser diode by measuring a portion of the laser beam and comparing the signal obtained from the measurement with a reference signal,
**characterized in**
that the bias current or the bias current and the modulating current is/are controlled in such a way that the laser diode operates in the region of the knee in the characteristic (threshold current), which results in a reduction in transmission bandwidth or a turnon delay and, thus, a particular spectral line in the optical power spectrum of the laser diode, that said spectral is measured by a measuring device, and

EP 0 237 922 B1

that from the measured value, a control signal is derived which controls the bias current or the bias current and the modulating current ($I_{Mod}$) via the first control device in such a way that the spectral line remains at a value below a maximum permissible value.

9. A method as claimed in claim 8, characterized in that a voltage corresponding to the measured laser-beam portion is applied to a first low-pass filter which forms an average voltage value therefrom and applies it to one input of a first comparator which, by comparing it with a reference voltage for the modulating current, which reference voltage is applied to the other input, adjusts the modulating current to a predetermined average power.

10. A method as claimed in claim 8 or 9, characterized in that the special line in the power spectrum is detected by applying the high-frequency component of the measured laser-beam portion and the system-clock frequency, corresponding to the bit rate or a multiple thereof, to a multiplier, passing the output of the multiplier through a second low-pass filter, and applying it as a controlled variable to one input of a second comparator having a reference voltage applied to the other input, and that the output signal obtained by comparing the two inputs adjusts the bias current to a value corresponding to the desired minimum magnitude of the spectral line in the spectrum of the optical laser power.

**Revendications**

1. Emetteur optique pour la transmission numérique d'informations au moyen d'impulsions NRZ, comprenant une diode laser (LD) à courant de seuil ($I_S$) et dont le courant de fonctionnement est compose d'un courant de polarisation ($I_V$) et un courant de modulation ($I_{Mod}$) et qui comporte une photodiode (PD) pour la mesure de la puissance optique de la diode laser (LD) et un premier dispositif de réglage (2), au moyen duquel le courant de polarisation ($I_V$) et le courant de modulation ($I_{Mod}$) sont réglables grâce à un courant généré par la photodiode (PD) et contenant une composante alternative, ainsi qu'un premier élément de commande, caractérisé en ce que le premier dispositif de réglage (2) comporte un multiplicateur (M) permettant de multiplier la composante alternative du courant généré par la photodiode (PD) par un signal de rythme dont la fréquence correspond à la fréquence du débit binaire ($f_B$) des impulsions NRZ, et en ce que le courant de polarisation ($I_V$) est susceptible d'être commandé par un signal de sortie émis par le premier dispositif de réglage (2) à l'aide du premier élément de commande pour une valeur qui est inférieure au courant de seuil ($I_S$).

2. Emetteur optique selon la revendication 1, caractérisé en ce que le premier dispositif de réglage (2) comporte un premier élément passe-bas (TP2) qui est branché en aval du multiplicateur (M) ainsi qu'un comparateur (K2) susceptible de recevoir le signal de sortie du premier élément passe-bas (TP2) et une tension de référence (U2), et en ce que la tension de référence (U2) correspond à la valeur de consigne de la fréquence du débit binaire ($f_B$).

3. Emetteur optique selon la revendication 1 ou 2, caractérisé en ce qu'il comporte un deuxième dispositif de réglage (1) permettant, grâce à un deuxième élément de commande, le réglage du courant de modulation ($I_{Mod}$) en fonction de la composante continue du courant fourni par la photodiode (PD) d'une telle façon que la puissance moyenne de la diode laser (LD) soit constante.

4. Emetteur optique selon la revendication 3, caractérisé en ce que le deuxième dispositif de réglage (1) comprend un deuxième élément passe-bas (TP1) et un deuxième comparateur (K1) Susceptible de recevoir le signal de sortie du deuxième élément passe-bas (TP1) et une deuxième tension de référence (U1), et en ce que cette tension de référence correspond à la valeur de consigne de la puissance moyenne de la diode laser (LD).

5. Emetteur optique selon la revendication 3 ou 4, caractérisé en ce que le réglage de la diode laser (LD) par le deuxième dispositif de réglage (1) est réalisé pour une fréquence limite plus élevée, c'est-à-dire une constante de temps de réglage plus petite, que pour le réglage au moyen du premier dispositif de règlage (2).

6. Emetteur optique selon la revendication 1 ou 2, caractérisé en ce qu'est branché sur l'une des deux entrées du multiplicateur (M) un dispositif de retard dont le retard peut être fixé ou réglé de telle manière que, par suite du décalage de phase entre les signaux d'entrée du multiplicateur (M),

7

apparaisse une composante continue optimale dans le signal de sortie du multiplicateur (M).

**7.** Emetteur optique selon l'une des revendications précédentes, caractérisé en ce que les éléments de commande sont composés chacun d'au moins un étage à transistor (T3, T4) et la sortie d'un comparateur respectif (K1, K2) est reliée à l'entrée de commande de chaque élément de commande associé.

**8.** Procédé pour le fonctionnement de l'émetteur optique selon la revendication 1, dans lequel on règle la puissance optique de la diode laser à courant de fonctionnement composé du courant de polarisation et du courant de modulation et dans lequel le courant de polarisation et le courant de modulation sont réglés séparément en fonction de la puissance optique de la diode laser obtenue par mesure d'un faisceau partiel du faisceau laser et par comparaison du signal qui en résulte avec un signal de référence au moyen du premier dispositif de réglage, caractérisé en ce que le courant de polarisation ou le courant de polarisation et le courant de modulation est(sont) réglé(s) de telle manière que la diode laser fonctionne dans la région du coude des lignes caractéristiques (courant de seuil) de manière à faire apparaître une réduction de la largeur de bande de transmission ou respectivement un retard de l'instant d'activation par voie de conséquence une ligne spectrale déterminée dans le spectre de puissance du flux lumineux de la diode laser, en ce que cette ligne spectrale est mesurée au moyen d'un dispositif de mesure et, à partir de cette mesure, on émet un signal de commande qui régule, via le premier dispositif de réglage, le courant de polarisation ou le courant de polarisation et le courant de modulation, de telle façon que la ligne spectrale reste inférieure à une valeur maximale admissible.

**9.** Procédé selon la revendication 8, caractérisé en ce qu'une tension qui correspond au courant partiel mesuré du laser est adressée à un premier élément passe-bas qui forme en conséquence une valeur moyenne de tension qui est appliquée à l'une des entrées d'un premier comparateur qui, par comparaison avec une tension de référence pour le courant de modulation appliquée à l'autre entrée, règle le courant de modulation sur une puissance moyenne prédéterminée.

**10.** Procédé selon la revendication 8 ou 9, caractérisé en ce qu'on détecte la ligne spectrale dans le spectre de puissance en appliquant la partie à haute fréquence du faisceau laser partiel mesuré et la fréquence du débit binaire ou une fréquence correspondante de rythme du système qui est un multiple de ce débit à un multiplicateur, et on transmet le signal de sortie du multiplicateur, via un deuxième élément passe-bas, en tant que valeur de réglage à l'une des entrées d'un deuxième comparateur, dont l'autre entrée reçoit une tension de référence, et en ce que le signal de sortie formé par une comparaison des deux grandeurs d'entrée régule le courant de polarisation à une valeur qui correspond à la grandeur minimale souhaitée de la ligne spectrale dons le spectre de puissance du flux lumineux du laser.

Fig.1

Fig.2

9